# FASCICULE DE BREVET EUROPEEN

(11) **EP 2 721 911 B1**
(45) Date de publication et mention de la délivrance du brevet: **31.08.2016**
(21) Numéro de dépôt: 12702237.4
(22) Date de dépôt: 31.01.2012
(51) Int. Cl.: H05K 1/18, H05K 3/20, H05K 3/40, H01M 2/20, H01M 10/48

(54) **CIRCUIT IMPRIME POUR L'INTERCONNEXION ET LA MESURE D'ACCUMULATEURS D'UNE BATTERIE**
LEITERPLATTE FÜR VERBINDUNG UND MESSUNG VON BATTERIEZELLEN IN EINER BATTERIE
PRINTED CIRCUIT FOR INTERCONNECTING AND MEASURING BATTERY CELLS IN A BATTERY

(30) Priorité: 17.06.2011 FR 1155350
(43) Date de publication de la demande: 23.04.2014
(73) Titulaire: Commissariat à l'Énergie Atomique et aux Énergies Alternatives, 75015 Paris (FR)
(72) Inventeur: DESBOIS-RENAUDIN, Matthieu, F-38250 Villard De Lans (FR); DE PAOLI, Lionel, F-69460 Odenas (FR)
(74) Mandataire: Colombo, Michel
(86) Numéro de dépôt international: PCT/EP2012/051595
(87) Numéro de publication internationale: WO 2012/171668

(56) Documents cités:
- WO-A1-2011/033059
- DE-A1-102007 031 857
- DE-A1-102008 034 871
- US-A1- 2008 254 356
- US-A1- 2008 286 640

## Description

L'invention concerne les batteries d'accumulateurs électrochimiques. Celles-ci peuvent par exemple être utilisées dans le domaine des transports électriques et hybrides ou les systèmes embarqués.

Un accumulateur électrochimique a habituellement une tension nominale de l'ordre de grandeur suivant :
1.2 V pour des batteries de type NiMH,
3.3 V pour une technologie lithium-ion phosphate de Fer, LiFePO4,
4.2 V pour une technologie de type lithium-ion à base d'oxyde de cobalt.

Ces tensions nominales sont trop faibles par rapport aux exigences de la plupart des systèmes à alimenter. Pour obtenir le niveau de tension adéquat, on place en série plusieurs accumulateurs. Pour obtenir de fortes puissances et capacités, on place plusieurs accumulateurs en parallèle. Le nombre d'étages (nombre d'accumulateurs en série) et le nombre d'accumulateurs en parallèle dans chaque étage varient en fonction de la tension, du courant et de la capacité souhaités pour la batterie. L'association de plusieurs accumulateurs est appelée une batterie d'accumulateurs.

Lors de la conception d'une batterie d'accumulateurs, on cherche à fournir un certain niveau de puissance sous une tension de fonctionnement définie. Pour maximiser la puissance, on maximise le courant délivré en réduisant autant que possible la résistance interne parasite de la batterie.

Les batteries de type lithium-ion sont bien adaptées pour des applications de transport par leur capacité à stocker une énergie importante dans une faible masse. Parmi les technologies de batteries lithium-ion, les batteries à base de phosphate de fer offrent un haut niveau de sécurité intrinsèque par rapport aux batteries lithium-ion à base d'oxyde de cobalt, au détriment d'une énergie massique un peu inférieure. Par ailleurs, les batteries lithium-ion présentent aussi une tension minimale en dessous de laquelle un accumulateur peut subir une dégradation.

En pratique, pour des applications de forte puissance, il est nécessaire de concevoir spécifiquement une batterie présentant une tension de sortie, une capacité et une puissance adaptées pour cette application. La conception implique notamment le choix du type d'accumulateurs, le choix d'un nombre d'étages d'accumulateurs connectés en série, et le choix d'un nombre de branches connectées en parallèle.

La batterie fabriquée doit répondre à un certain nombre de contraintes, notamment une résistance mécanique, une sécurité contre l'échauffement, l'apparition de court-circuit ou la présence de corps étrangers, des pertes électriques aussi réduites que possible, un encombrement et un prix de revient aussi réduits que possible. Un circuit de contrôle doit également veiller à ce que la tension des accumulateurs soit maintenue entre la tension minimale et la tension maximale de fonctionnement.

Une solution existante consiste à visser des barres conductrices formant une connexion électrique de puissance sous forme de bus. Ces barres sont vissées sur les accumulateurs. Une prise de mesure de tension est effectuée par une cosse serrée au même point que le vissage d'une barre conductrice. Cette solution présente plusieurs inconvénients : les fils libres dans un pack batterie sont une source sérieuse de risque de court-circuit et leur mise en place est fastidieuse et non automatisable.

Une autre solution consiste en l'utilisation d'un circuit imprimé de faible épaisseur, sur lequel est collée une plaque de cuivre d'environ 1 mm d'épaisseur. Cette plaque est ensuite usinée, de façon à séparer électriquement des zones qui serviront de connexion de puissance entre les accumulateurs électrochimiques. L'information de tension est remontée sur les pistes du circuit imprimé par l'intermédiaire de rivets conducteurs (cuivre...). Cette solution améliore sensiblement la sécurité mais n'autorise pas l'ajout de composants montés en surface sur les circuits imprimés étant donné la flexibilité de ces derniers. C'est en effet le circuit imprimé qui absorbe les écarts de hauteurs entre les bornes des différents accumulateurs électrochimiques.

Une autre solution est décrite dans le document US2008/0254356. Ce document décrit une structure d'interconnexion entre des accumulateurs d'une batterie et de connexion à un circuit de surveillance de charge de la batterie. La batterie est incluse dans un outil portatif et la supervision de la charge des accumulateurs est prépondérante pour garantir sa durée de vie.

Une structure d'interconnexion est formée d'une feuille métallique assurant à la fois la connexion électrique série entre des accumulateurs et une connexion électrique avec un circuit de mesure de tension formé dans un substrat de circuit imprimé. La feuille métallique est repliée à angle droit pour délimiter deux pattes pour la fixation sur le substrat d'une part, et une plaque venant se souder sur des bornes d'accumulateurs d'autre part. Chaque patte de fixation est traversée par un rivet. Par l'utilisation d'une feuille métallique suffisamment fine, celle-ci peut être déformée au niveau de la jonction entre les pattes de fixation et la plaque, de façon à permettre d'absorber des dispersions entre les accumulateurs ou des dilatations thermiques de ces accumulateurs. Une conduction à travers la plaque et les pattes de fixation permet en outre au circuit de mesure de récupérer la tension sur une borne d'un accumulateur soudé sur la plaque. La finesse de la feuille métallique permet également d'absorber les vibrations induites par l'outil portatif (typiquement une perceuse) et ainsi de protéger le circuit imprimé. La finesse de la feuille métallique permet en outre de réaliser l'assemblage par soudure entre la plaque et les bornes des accumulateurs.

En pratique, une telle structure d'interconnexion ne permet qu'un débattement assez réduit pour les accumulateurs. En outre, une telle structure d'interconnexion n'est pas appropriée pour la conduction de courants importants et s'avère donc inadaptée pour des batteries de puissance. De plus, pour assurer une fixation satisfaisante de la structure d'interconnexion sur le substrat du circuit imprimé, cette fixation occupe un espace important de ce substrat. De plus, l'opération de fixation nécessite une très grande précision et impose certaines conditions de dimensionnement.

Le document WO2011/033059 décrit un circuit imprimé fixé à une batterie et comportant un substrat avec des pistes conductrices et un circuit de mesure de tension connecté aux pistes conductrices Un élément d'interconnexion flexible est utilisé pour une interconnexion entre des accumulateurs et des pistes conductrices.

Le document US2008/286640 décrit un pack de batterie pour appareil électrique portatif comportant un circuit imprimé connecté à des accumulateurs par une feuille métallique.

Le document DE10 2008 034 871 décrit des lamelles d'interconnexion en série entre des accumulateurs. Ces lamelles d'interconnexion sont pliées.

Le document DE10 2007 031 857 décrit un pack d'accumulateurs pour un appareil électroportatif. Une feuille d'interconnexion entre des accumulateurs est surmontée d'une isolation électrique.

L'invention vise à résoudre un ou plusieurs de ces inconvénients. L'invention porte ainsi sur un circuit imprimé destiné à être fixé à une batterie d'accumulateurs, comportant:
- un substrat comportant des pistes conductrices ;
- un circuit de mesure de tension connecté aux pistes conductrices ;
- un élément d'interconnexion électrique, formé d'un seul tenant,conducteur et flexible, l'élément d'interconnexion présentant une épaisseur comprise entre 0,3mm et 1,5mm, l'élément d'interconnexion comportant :
   - une unique portion fixée audit substrat, fixée au substrat par plusieurs emmanchements en force et connectée électriquement à une desdites pistes conductrices ;
   - au moins deux portions en porte à faux par rapport à la portion fixe et mobiles par rapport au substrat, lesdites deux portions en porte-à-faux sont formées aux extrémités d'une lame conductrice disposée en porte à faux par rapport à la portion fixe, ladite lame conductrice étant raccordée à la portion fixe par l'intermédiaire d'une jonction dont la largeur est inférieure à la largeur de la lame conductrice.

Selon une variante, la distance entre la portion fixe et le point distal des portions en porte-à-faux est supérieur à 35 mm.

Selon l'invention, le substrat comporte des orifices traversants et les portions en porte-à-faux sont disposées à l'aplomb de deux orifices traversants respectifs.

Selon une autre variante, les portions en porte-à-faux comportent des orifices traversants localisés à l'aplomb d'orifices traversants respectifs du substrat.

Selon encore une autre variante, ledit substrat présente une épaisseur supérieure à 1,5 mm.

Selon une variante, le circuit imprimé comprend en outre des composants électroniques montés en surface connectés à au moins une desdites pistes conductrices.

Selon une autre variante, l'élément d'interconnexion est réalisé dans un matériau choisi dans le groupe comprenant les alliages d'aluminium et les alliages de cuivre.

L'invention porte également sur une batterie, comprenant :
- un circuit imprimé tel que décrit ci-dessus ;
- un support auquel le circuit imprimé est fixé ;
- au moins deux accumulateurs électrochimiques logés dans ledit support et comportant chacun une borne connectée à une portion en porte-à-faux respective de l'élément d'interconnexion du circuit imprimé.

Selon une variante, lesdits accumulateurs électrochimiques comportent chacun deux bornes de connexion disposées à une même extrémité de l'accumulateur.

Selon une autre variante, la batterie comprend un matériau compressible interposé entre le support et l'extrémité d'un accumulateur opposée à l'extrémité comportant lesdites bornes de connexion.

Selon une autre variante, la batterie comprend un circuit imprimé et des vis traversant les orifices des portions en porte-à-faux et solidarisant les portions en porte-à-faux à une borne respective desdits accumulateurs.

Selon encore une autre variante, le circuit imprimé comprend un circuit d'équilibrage de la charge desdits accumulateurs connecté auxdites pistes conductrices.

Selon une variante, le circuit imprimé comporte :
- deux bornes de sortie de puissance de la batterie ;
- deux autres éléments d'interconnexion conducteurs connectés électriquement à une borne de sortie de puissance respective, fixés au substrat et connectant chacun des bornes de plusieurs accumulateurs électrochimiques.

D'autres caractéristiques et avantages de l'invention ressortiront clairement de la description qui en est faite ci-après, à titre indicatif et nullement limitatif, en référence aux dessins annexés, dans lesquels :
- la figure 1 est une vue en coupe de côté d'une batterie selon un mode de réalisation de l'invention ;
- la figure 2 est une vue de dessous d'un circuit imprimé de la batterie de la figure 1 ;
- la figure 3 est une vue de dessus d'un circuit imprimé de la batterie de la figure 1 ;
- la figure 4 est une vue en coupe de côté de détails d'un élément d'interconnexion subissant des déformations ;
- la figure 5 est une vue de dessous de l'élément d'interconnexion de la figure 4 ;
- la figure 6 est une vue de dessus de l'élément d'interconnexion de la figure 4 ;
- la figure 7 est une vue en coupe de côté de détails d'une variante d'élément d'interconnexion subissant des déformations ;
- la figure 8 est une vue de dessus de l'élément d'interconnexion de la figure 7 avant son emmanchement en force.

L'invention propose un circuit imprimé destiné à être fixé sur une batterie, en particulier sur une batterie de puissance (présentant typiquement une tension supérieure à 24V et une capacité supérieure à 10 Ah). Le circuit imprimé comporte un substrat muni de pistes conductrices connectées à un circuit de mesure de tension (et avantageusement à un circuit d'équilibrage de charge). Le circuit imprimé comporte en outre au moins un élément d'interconnexion électrique de puissance, formé d'un seul tenant, conducteur et flexible. Pour favoriser à la fois la conduction électrique et la flexibilité, l'élément d'interconnexion présente avantageusement une épaisseur comprise entre 0,3 mm et 1,5 mm. Cet élément d'interconnexion comporte une unique portion fixée au substrat et connectée à une des pistes conductrices. Cette unique portion fixe est fixée au substrat par plusieurs emmanchements en force. L'élément d'interconnexion comporte également deux portions en porte-à-faux par rapport à la portion fixe, ces portions en porte-à-faux étant formées aux extrémités d'une lame conductrice disposée en porte-à-faux par rapport à la portion fixe. La lame conductrice est raccordée à la portion fixe par l'intermédiaire d'une jonction dont la largeur est inférieure à la largeur de la lame conductrice. Ces portions en porte-à-faux sont mobiles par rapport au substrat.

Les portions en porte-à-faux assurent une connexion de puissance entre deux bornes appartenant à deux accumulateurs de la batterie. Du fait du dimensionnement de l'élément d'interconnexion, un courant de puissance en série peut donc traverser la lame de l'élément d'interconnexion. Ce courant de puissance pourra par exemple présenter une amplitude nominale comprise entre 30 et 500A. Du fait de la flexibilité de l'élément d'interconnexion, les portions en porte-à-faux peuvent se déplacer par rapport au substrat par flexion de la lame, et/ou par torsion de sa jonction à la portion fixe. L'utilisation d'une unique portion fixée et d'une jonction de largeur réduite favorise une telle torsion. La présence de plusieurs emmanchements en force permet d'assurer la connexion électrique entre les bornes des accumulateurs et les pistes conductrices à la fois sur une surface réduite et en empêchant un pivotement de l'élément d'interconnexion autour d'un axe normal au substrat. La portion fixée permet d'assurer d'une part la tenue mécanique de l'élément d'interconnexion sur le substrat et d'autre part une connexion électrique entre les bornes des deux accumulateurs et le circuit de mesure.

Ainsi, le circuit imprimé peut être fixé directement sur la batterie en assurant à la fois une connexion de puissance entre accumulateurs et une connexion au circuit de mesure, sans que le circuit imprimé et ses composants électroniques ne soient excessivement déformés du fait de dispersions de fabrication entre les différents accumulateurs, de dilatations thermiques distinctes entre ces accumulateurs, ou de toute autre sollicitation mécanique (vibrations, chocs, accélérations dans les 3 directions...).

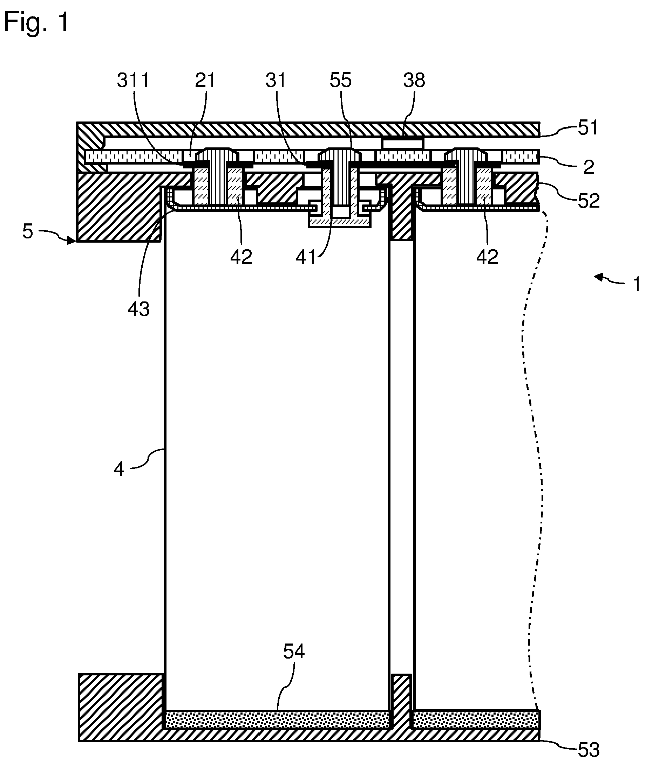

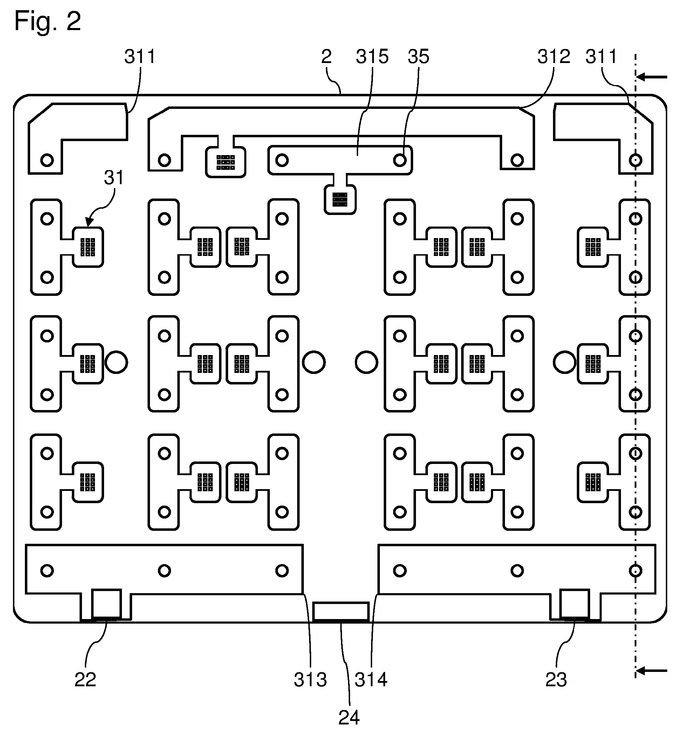

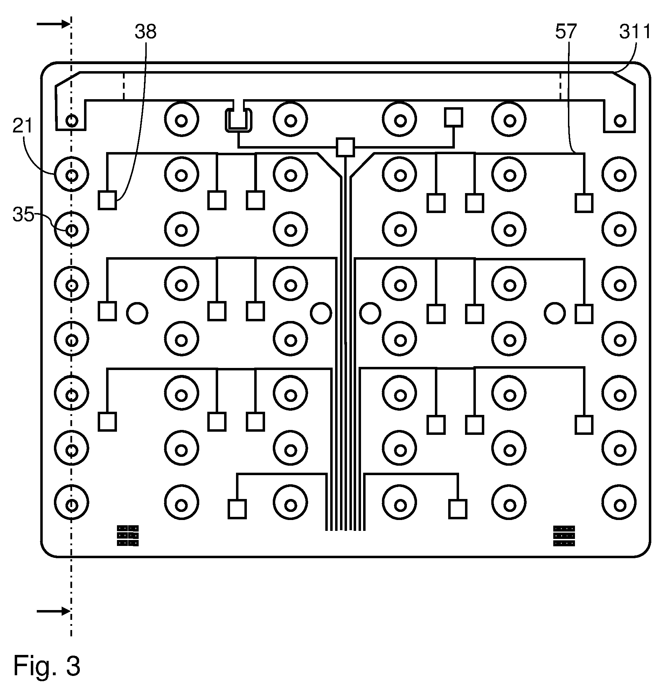

La figure 1 est une vue en coupe partielle de côté d'une batterie 1 selon un mode de réalisation de l'invention. La batterie 1 comprend un circuit imprimé 2 illustré de façon plus détaillée en vue de dessous et en vue de dessus respectivement à la figure 2 et à la figure 3.

La batterie 1 comprend un support 5. Le support 5 est destiné à loger une pluralité d'accumulateurs 4 de la batterie, et destiné à recevoir le circuit imprimé 2. Le support 5 comprend avantageusement un flasque inférieur 53 et un flasque supérieur 52. Les accumulateurs 4 sont maintenus entre les flasques 52 et 53. Des premières extrémités axiales des accumulateurs 4 sont placées dans des logements respectifs du flasque supérieur et des deuxièmes extrémités axiales des accumulateurs 4 sont placées dans des logements respectifs du flasque inférieur. Les accumulateurs 4 s'étendent ainsi axialement entre les flasques 52 et 53. Les logements des flasques 52 et 53 sont avantageusement configurés pour brider les mouvements axiaux et transversaux des accumulateurs 4. Les accumulateurs 4, ainsi maintenus suivant les différents axes par les flasques 52 et 53, sont avantageusement séparés par un intervalle d'air. Des arbres rapportés (non illustrés) solidarisent les flasques 52 et 53. Les arbres rapportés s'étendent selon l'axe des accumulateurs 4 et permettent d'exercer un effort de maintien entre les flasques 52 et 53.

Dans l'exemple illustré, les accumulateurs 4 comportent des bornes de connexion 41 et 42 disposées au niveau d'une même extrémité axiale. De tels accumulateurs 4 permettent une interconnexion facilitée. Les bornes 41 et 42 sont fixées de façon connue en soi sur un flasque 43 à une extrémité de l'accumulateur 4. Les bornes 41 et 42 traversent des orifices (non référencés) ménagés dans le flasque supérieur 52. Une garniture en matériau compressible 54 (par exemple en mousse) est avantageusement disposée entre une extrémité des accumulateurs 4 et un des flasques. Le matériau compressible peut être configuré pour permettre sa déformation d'environ 1 mm par serrage des arbres solidarisant les flasques 52 et 53. Dans l'exemple illustré, la garniture 54 est disposée dans les fonds des logements du flasque inférieur 53, au niveau de l'extrémité de l'accumulateur 4 opposée aux bornes 41 et 42. La garniture 54 permet de compenser les dispersions sur la dimension axiale des différents accumulateurs 4 et la dilatation thermique de ces accumulateurs 4.

Le support 5 comprend en outre un élément de maintien 51 avantageusement fixé sur le flasque supérieur 52. Le circuit imprimé 2 est fixé à cet élément de maintien 51. Le circuit imprimé 2 comporte un substrat. Les éléments d'interconnexion 31 et 311 sont fixés sur ce substrat. Les bornes 41 et 42 des accumulateurs 4 sont connectées électriquement à ces éléments d'interconnexion. Les bornes 41 et 42 sont fixées aux éléments d'interconnexion par l'intermédiaire de vis 55. Les bornes 41 et 42 peuvent également être fixées aux éléments d'interconnexion par tout autre moyen de fixation tel que soudure, rivet ou sertissage mécanique. Les vis 55 traversent des orifices traversants 21 ménagés dans le substrat.

Le circuit imprimé 2 illustré aux figures 2 et 3 est configuré pour connecter en série huit étages de trois accumulateurs 4 en parallèle. Le circuit imprimé 2 comporte une borne positive de sortie de puissance 22, et une borne négative de sortie de puissance 23. La borne 22 est connectée à un élément d'interconnexion 313 destiné à être connecté aux bornes positives de trois accumulateurs. La borne 23 est connectée à un élément d'interconnexion 314 destiné à être connecté aux bornes négatives de trois accumulateurs. Les éléments d'interconnexion 313 et 314 sont disposés au niveau d'un même bord du circuit imprimé 2. Le circuit imprimé 2 comprend en outre une pluralité d'éléments d'interconnexion 31, chacun destiné à connecter en série deux accumulateurs 4. Le circuit imprimé 2 comprend en outre un élément d'interconnexion 311, un élément d'interconnexion 312 et un élément d'interconnexion 315.

Les éléments d'interconnexion sont conducteurs et flexibles. L'élément d'interconnexion 311 comporte une partie s'étendant sur la face supérieure du substrat et des portions mobiles s'étendant sur la face inférieure du substrat. Les lignes en trait discontinu illustrent la jonction entre les portions mobiles et la partie supérieure de l'élément d'interconnexion 311. Des orifices correspondants sont ménagés dans le substrat. Les éléments d'interconnexion 31, 312, 313, 314 et 315 comportent une portion fixe 33 fixée au substrat du circuit 2 sur sa face inférieure. Cette portion fixe 33 permet à la fois de fixer ces éléments d'interconnexion au substrat et d'assurer leur connexion électrique avec des pistes conductrices 57 ménagées sur la face supérieure du substrat. Les éléments d'interconnexion 31, 312, 313, 314 et 315 comportent également deux portions en porte-à-faux par rapport à la portion fixe 33. Les portions en porte-à-faux sont en l'occurrence formées d'une lame 36 disposée en porte-à-faux par rapport à la portion fixe 33.

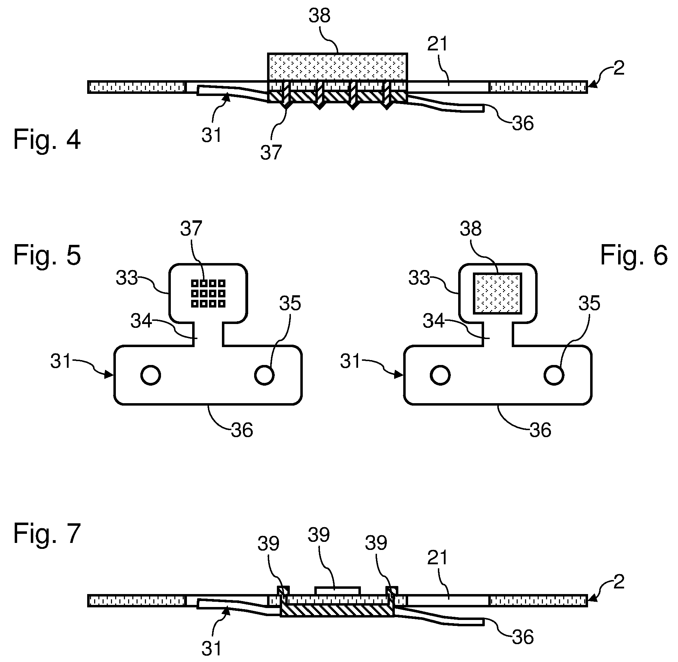

L'élément d'interconnexion 31 selon une première variante de l'invention est illustré de façon plus détaillée en vue de dessous et en vue de dessus respectivement aux figures 5 et 6. La lame 36 est reliée à la portion fixe 33 par l'intermédiaire d'une jonction conductrice 34. La jonction conductrice 34 assure la conduction électrique entre la lame 36 et la portion fixe 33. La lame 36 assure la connexion électrique de puissance entre deux de ses extrémités destinées à être connectées à des bornes d'accumulateurs 4. La lame 36, et en particulier ses extrémités, sont mobiles par rapport au substrat. Ainsi, les extrémités de la lame 36 peuvent se déplacer selon la direction de l'axe des accumulateurs 4, par flexion de la lame 36, sans pour autant induire d'efforts inappropriés sur le substrat. En outre, les extrémités de la lame 36 peuvent se déplacer selon la direction de l'axe des accumulateurs, par torsion de la jonction 34. Cette torsion est favorisée par la présence d'une unique portion 33 fixée au circuit imprimé 2, même lorsque l'élément d'interconnexion 31 est relativement épais en vue de favoriser la conduction électrique d'une batterie de puissance. Cette torsion est également favorisée par la jonction 34 présentant une largeur inférieure à la largeur de la lame 36 : on garantit ainsi une conduction électrique optimale entre les extrémités de la lame 36 tout en favorisant la flexion de la jonction 34, même lorsque l'élément d'interconnexion 31 est relativement épais en vue de favoriser la conduction électrique d'une batterie de puissance. Le placement des extrémités de la lame 36 en porte-à-faux par rapport à la jonction 34 permet de tolérer un déplacement important des bornes des accumulateurs qui y sont fixées, même lorsque l'élément d'interconnexion 31 est relativement épais en vue de favoriser la conduction électrique d'une batterie de puissance. Ainsi, les éléments d'interconnexion peuvent aisément s'adapter aux dispersions de fabrication des accumulateurs 4 ou à leur dilatation thermique (parfois distinctes, du fait d'un refroidissement potentiellement non homogène). La jonction 34 permet de démultiplier l'amplitude du déplacement des extrémités de la lame 36 pour un effort donné. Avantageusement, la portion fixe 33 présente une largeur supérieure à celle de la jonction 34. Ainsi, la portion fixe 33 permet de garantir une grande surface de contact électrique et de fixation pour l'élément d'interconnexion avec le substrat. Un tel élément d'interconnexion 31 permet d'obtenir un débattement des extrémités de la lame 36 important avec un encombrement réduit.

Un exemple de lame 36 d'un élément d'interconnexion 31 est fléchi par des bornes d'accumulateurs 4 à la figure 4. Dans cet exemple, une des extrémités de la lame 36 est déplacée vers le bas, tandis qu'une autre des extrémités de la lame 36 est déplacée vers le haut. L'extrémité déplacée vers le haut est déplacée à l'intérieur d'un orifice 21 ménagé dans le substrat.

La fixation des éléments d'interconnexion 31, 311, 312, 313, 314 et 315 au substrat du circuit imprimé 2 est réalisée par plusieurs emmanchements en force. L'utilisation de plusieurs emmanchements en force permet d'assurer un contact en plusieurs points avec les pistes conductrices du circuit imprimé 2. L'utilisation de plusieurs emmanchements en force permet de bloquer la rotation de l'élément d'interconnexion 31 autour d'un axe normal au circuit imprimé 2.

Dans l'exemple illustré à la figure 4, des tiges conductrices 37 traversent le substrat du circuit imprimé 2 pour assurer la fixation de l'élément d'interconnexion au substrat. Les tiges 37 assurent avantageusement également la connexion électrique entre la partie fixe 33 et les pistes conductrices 57. À cet effet, les tiges 37 sont emmanchées en force dans le substrat du circuit imprimé 2 et dans la partie fixe 33. Des orifices sont ainsi prévus dans le substrat et dans la partie fixe 33 afin de déformer les tiges 37 lors de leur emmanchement en force. Les orifices du substrat sont avantageusement métallisés pour assurer un contact électrique avec les pistes conductrices du circuit imprimé. Les tiges 37 peuvent être fixées dans un support de manipulation 38. La combinaison des tiges 37 et du support de manipulation 38 peut être réalisée sous la forme d'inserts emboutis (connus sous la dénomination press fit inserts en langue anglaise). L'utilisation d'un tel insert embouti permet de réaliser la fixation de l'élément d'interconnexion sur le substrat du circuit imprimé 2 en une seule opération, et dans un encombrement réduit. Des inserts tels que ceux commercialisés sous la référence commerciale Press Fit par la société Wurth Elektronik peuvent notamment être utilisés. L'extrémité libre des tiges 37 peut être déformée plastiquement pour former des bourrelets renforçant la liaison mécanique.

Les pistes conductrices 57 sont connectées à un circuit de mesure de tension 24. Le circuit 24 peut être réalisé avec des composants électroniques montés en surface. Par l'intermédiaire des pistes conductrices 57, le circuit de mesure de tension 24 peut mesurer la tension aux bornes de chacun des accumulateurs 4. Le circuit de mesure de tension 24 peut notamment être inclus dans un circuit de contrôle de la charge de la batterie 1. Ce circuit de contrôle de la charge de la batterie 1 peut également réaliser des charges ou des décharges des différents étages d'accumulateurs 4, par l'intermédiaire des pistes conductrices 57. Ce circuit de contrôle peut ainsi procéder à un équilibrage des charges des différents étages de la batterie 1. Les éléments d'interconnexion 311, 312 et 315 permettent de connecter en série les bornes d'accumulateurs 4 appartenant à deux côtés opposés de la batterie 1.

Le substrat du circuit imprimé 2 présente avantageusement une pluralité d'orifices traversants 21 disposés à l'aplomb des portions mobiles des éléments d'interconnexion. Ces orifices traversants 21 permettent d'une part d'accroître la mobilité des portions mobiles vers le haut. Ces orifices 21 permettent en outre de fixer les bornes des accumulateurs 4 sur les éléments d'interconnexion. Dans l'exemple, les portions mobiles des éléments d'interconnexion présentent avantageusement des orifices traversants 35, destinés à fournir un passage pour le corps des vis 55 fixées dans des bornes 41 et 42. Les orifices traversants 35 sont ainsi disposés à l'aplomb des orifices traversants 21. On peut également envisager de réaliser la connexion électrique et la connexion mécanique des bornes 41 et 42 aux éléments d'interconnexion par tout autre moyen approprié, par exemple par soudure. Les orifices 21 fournissent alors un accès à des électrodes de soudure.

Les éléments d'interconnexion sont formés d'un seul tenant dans un matériau conducteur. De tels éléments d'interconnexion peuvent notamment être réalisés relativement aisément par emboutissage ou en tôle découpée-pliée. De tels éléments d'interconnexion peuvent par exemple être réalisés en alliage d'aluminium, en bronze phosphoreux ou en tout alliage de cuivre, matériaux relativement aisés à transformer et présentant des propriétés de conduction électrique et de flexibilité intéressantes. Afin d'être aisément déformable, un élément d'interconnexion en cuivre présentera une épaisseur comprise entre 0,3 et 1,5 mm. Pour favoriser la flexion des portions en porte-à-faux, la distance entre la portion fixe 33 et le point distal des portions en porte-à-faux est avantageusement supérieur à 35 mm.

Afin de réduire au maximum les déformations induites par les accumulateurs 4 sur le circuit imprimé 2, le substrat présente avantageusement une épaisseur supérieure à 1,5 mm. Le substrat présentera avantageusement un module d'élasticité supérieur à 15 000 MPa. Le substrat pourra par exemple être réalisé en résine époxyde. Le substrat pourra comporter plusieurs couches de pistes de cuivre. Une telle configuration assurera une protection et une fiabilité optimales d'éventuels composants électroniques montés en surface sur le substrat du circuit imprimé 2. Les éléments d'interconnexion et le substrat seront avantageusement dimensionnés de sorte que la déformation maximale induite sur le substrat par les bornes 41 ou 42 soit au moins 5 fois inférieure à la déformation maximale d'un élément d'interconnexion par ces bornes 41 ou 42.

La figure 7 illustre une autre variante d'un élément d'interconnexion 31. Cette variante diffère de la variante des figures 4 à 6 uniquement par la structure de la portion fixe. Selon cette variante, l'élément d'interconnexion 37 comporte des languettes 39, formées d'un seul tenant dans la portion fixe 33. La portion fixe 33 comporte une partie médiane plate. Les languettes 39 sont par exemple formées par pliage de saillies de la portion fixe 33, de façon à les orienter selon la normale à la partie médiane de la portion fixe 33. Comme illustré, les languettes 39 traversent le substrat du circuit imprimé 2. Dans l'exemple illustré, les languettes s'étendent depuis plusieurs bords de la partie médiane de la portion fixe 33, ce qui permet d'assurer un meilleur blocage en rotation autour d'un axe normal au substrat du circuit imprimé 2. Dans cet exemple, les languettes 39 traversent des orifices ménagés dans le substrat du circuit imprimé 2. Ces orifices sont ménagés de façon à déformer les languettes 39 lors de leur emmanchement en force dans ces orifices. Les orifices du substrat sont avantageusement métallisés pour assurer un contact électrique avec les pistes conductrices du circuit imprimé 2. De telles languettes 39 permettent de réaliser des connexions électriques et mécaniques multiples par emmanchement en force en une seule opération et dans un encombrement réduit. L'extrémité libre des languettes 39 peut être déformée plastiquement après l'emmanchement en force pour former des bourrelets renforçant la liaison mécanique.

Bien que l'invention ait été décrite dans un mode de réalisation avec des accumulateurs électrochimiques présentant des bornes de connexion à une même extrémité, l'homme du métier pourra également réaliser une batterie selon l'invention au moyen d'accumulateurs présentant des bornes de connexion à des extrémités opposées.

## Revendications

1. Circuit imprimé (2) destiné à être fixé à une batterie (1) d'accumulateurs, comportant :
- un substrat comportant des pistes conductrices (57) et des orifices traversants (21) ;
- un circuit de mesure de tension (24) connecté aux pistes conductrices ;
- un élément d'interconnexion électrique (31), formé d'un seul tenant,conducteur et flexible, l'élément d'interconnexion présentant une épaisseur comprise entre 0,3mm et 1,5mm, l'élément d'interconnexion comportant :
- une unique portion (33) fixée audit substrat, fixée au substrat par plusieurs emmanchements en force et connectée électriquement à une desdites pistes conductrices ; le circuit imprimé étant **caractérisé en ce que** l'élément d'interconnexion comporte :
- au moins deux portions en porte à faux par rapport à la portion fixe et mobiles par rapport au substrat, lesdites deux portions en porte-à-faux sont formées aux extrémités d'une lame conductrice (36) disposée en porte à faux par rapport à la portion fixe, ladite lame conductrice étant raccordée à la portion fixe par l'intermédiaire d'une jonction (34) dont la largeur est inférieure à la largeur de la lame conductrice, les portions en porte-à-faux (36) sont disposées à l'aplomb de deux orifices traversants (21) respectifs.

2. Circuit imprimé selon la revendication 1, dans lequel la distance entre la portion fixe (33) et le point distal des portions en porte-à-faux (36) est supérieur à 35 mm.

3. Circuit imprimé selon l'une quelconque des revendications précédentes, dans lequel les portions en porte-à-faux comportent des orifices traversants (35) localisés à l'aplomb d'orifices traversants (21) respectifs du substrat.

4. Circuit imprimé selon l'une quelconque des revendications précédentes, dans lequel ledit substrat présente une épaisseur supérieure à 1,5 mm.

5. Circuit imprimé selon l'une quelconque des revendications précédentes, comprenant en outre des composants électroniques montés en surface connectés à au moins une desdites pistes conductrices (57).

6. Circuit imprimé selon l'une quelconque des revendications précédentes, dans lequel l'élément d'interconnexion est réalisé dans un matériau choisi dans le groupe comprenant les alliages d'aluminium et les alliages de cuivre.

7. Batterie (1), comprenant :
- un circuit imprimé (2) selon l'une quelconque des revendications précédentes ;
- un support (5) auquel le circuit imprimé est fixé ;
- au moins deux accumulateurs électrochimiques (4) logés dans ledit support et comportant chacun une borne (41,42) connectée à une portion en porte-à-faux respective de l'élément d'interconnexion (31) du circuit imprimé.

8. Batterie selon la revendication 7, dans laquelle lesdits accumulateurs électrochimiques (4) comportent chacun deux bornes de connexion (41, 42) disposées à une même extrémité de l'accumulateur.

9. Batterie selon la revendication 8, comprenant un matériau compressible (54) interposé entre le support (53) et l'extrémité d'un accumulateur opposée à l'extrémité comportant lesdites bornes de connexion.

10. Batterie selon la revendication 7, 8 ou 9 comprenant un circuit imprimé selon la revendication 1, et comprenant des vis (55) traversant les orifices des portions en porte-à-faux et solidarisant les portions en porte-à-faux à une borne respective (41, 42) desdits accumulateurs.

11. Batterie selon l'une quelconque des revendications 7 à 10, dans laquelle le circuit imprimé comprend un circuit d'équilibrage de la charge desdits accumulateurs connecté auxdites pistes conductrices (56).

12. Batterie selon l'une quelconque des revendications 7 à 11, dans laquelle le circuit imprimé comporte
- deux bornes de sortie de puissance (22, 23) de la batterie ;
- deux autres éléments d'interconnexion conducteurs (313,314) connectés électriquement à une borne de sortie de puissance respective, fixés au substrat et connectant chacun des bornes de plusieurs accumulateurs électrochimiques.

## Patentansprüche

1. Gedruckte Schaltung (2), die dazu bestimmt ist, an einer Akkumulatorbatterie (1) befestigt zu werden, und die Folgendes umfasst:
- ein Substrat, das Leiterbahnen (57) und Durchgangsöffnungen (21) aufweist;
- eine Spannungsmessschaltung (24), die mit den Leiterbahnen verbunden ist;
- ein Element (31) für elektrischen Anschluss, das einteilig ausgebildet, leitend und biegsam ist, wobei das Anschlusselement eine Dicke im Bereich von 0,3 mm bis 1,5 mm aufweist, wobei das Anschlusselement Folgendes umfasst:
- einen einzigen Abschnitt (33), der an dem Substrat befestigt ist und an dem Substrat über mehrere Stifte mit Kraft befestigt ist und mit einer der Leiterbahnen elektrisch verbunden ist;
wobei die gedruckte Schaltung **dadurch gekennzeichnet ist, dass** das Anschlusselement Folgendes umfasst:
- wenigstens zwei in Bezug auf den festen Abschnitt überhängende und in Bezug auf das Substrat bewegliche Abschnitte, wobei die zwei überhängenden Abschnitte an den Enden eines leitenden Plättchens (36) gebildet sind, das in Bezug auf den festen Abschnitt überhängend angeordnet ist, wobei das leitende Plättchen mit dem festen Abschnitt über eine Verbindung (34) verbunden ist, deren Breite kleiner als die Breite des leitenden Plättchens ist, wobei die überhängenden Abschnitte (36) senkrecht zu zwei entsprechenden Durchgangsöffnungen (21) angeordnet sind.

2. Gedruckte Schaltung nach Anspruch 1, wobei der Abstand zwischen dem festen Abschnitt (33) und dem distalen Punkt der überhängenden Abschnitte (36) größer als 35 mm ist.

3. Gedruckte Schaltung nach einem der vorhergehenden Ansprüche, wobei die überhängenden Abschnitte Durchgangsöffnungen (35) aufweisen, die senkrecht zu entsprechenden Durchgangsöffnungen (21) des Substrats angeordnet sind.

4. Gedruckte Schaltung nach einem der vorhergehenden Ansprüche, wobei das Substrat eine Dicke von mehr als 1,5 mm aufweist.

5. Gedruckte Schaltung nach einem der vorhergehenden Ansprüche, die außerdem elektronische Komponenten umfasst, die oberflächenmontiert sind und mit wenigstens einer der Leiterbahnen (57) verbunden sind.

6. Gedruckte Schaltung nach einem der vorhergehenden Ansprüche, wobei das Anschlusselement aus einem Material verwirklicht ist, das aus der Gruppe gewählt ist, die Aluminiumlegierungen und Kupferlegierungen enthält.

7. Batterie (1), die Folgendes umfasst:
- eine gedruckte Schaltung (2) nach einem der vorhergehenden Ansprüche;
- einen Träger (5), an dem die gedruckte Schaltung befestigt ist;
- wenigstens zwei elektrochemische Akkumulatoren (4), die in dem Träger untergebracht sind und jeweils einen Anschluss (41, 42) umfassen, der mit einem entsprechenden überhängenden Abschnitt des Anschlusselements (31) der gedruckten Schaltung verbunden ist.

8. Batterie nach Anspruch 7, wobei die elektrochemischen Akkumulatoren (4) jeweils zwei Verbindungsanschlüsse (41, 42) umfassen, die am selben Ende des Akkumulators angeordnet sind.

9. Batterie nach Anspruch 8, die ein komprimierbares Material (54) aufweist, das zwischen dem Träger (53) und dem Ende eines Akkumulators gegenüber dem Ende, das die Verbindungsanschlüsse aufweist, eingefügt ist.

10. Batterie nach Anspruch 7, 8 oder 9, die eine gedruckte Schaltung nach Anspruch 1 enthält und Schrauben (55) aufweist, die durch die Öffnungen der überhängenden Abschnitte verlaufen und die überhängenden Abschnitte mit einem entsprechenden Anschluss (41, 42) der Akkumulatoren fest verbinden.

11. Batterie nach einem der Ansprüche 7 bis 10, wobei die gedruckte Schaltung eine Ladungsausgleichsschaltung der Akkumulatoren, die mit den Leiterbahnen (56) verbunden ist, umfasst.

12. Batterie nach einem der Ansprüche 7 bis 11, wobei die gedruckte Schaltung Folgendes umfasst:
- zwei Leistungsausgangsanschlüsse (22, 23) der Batterie;
- zwei andere Anschlussleiterelemente (313, 314), die mit einem entsprechenden Leistungsausgangsanschluss elektrisch verbunden sind, an dem Substrat befestigt sind und jeden der Anschlüsse mehrerer elektrochemischer Akkumulatoren verbinden.

## Claims

1. Printed circuit (2) intended to be fixed to an accumulator battery (1), comprising:
- a substrate comprising conducting tracks (57) and through orifices (21);
- a voltage measurement circuit (24) connected to the conducting tracks;
- an electrical interconnection element (31), formed as a single conducting and flexible whole, the interconnection element exhibiting a thickness of between 0.3 mm and 1.5 mm, the interconnection element comprising:
- a single portion (33) fixed to the said substrate, fixed to the substrate by several force fastenings and connected electrically to one of said conducting tracks;
the printed circuit being **characterized in that** the interconnection element comprises:
- at least two portions cantilevered with respect to the fixed portion and mobile with respect to the substrate, the said two cantilevered portions are formed at the ends of a conducting strip (36) disposed cantilevered with respect to the fixed portion, the said conducting strip being joined to the fixed portion by way of a junction (34) whose width is less than the width of the conducting strip, the cantilevered portions (36) are disposed plumb with two respective through orifices (21).

2. Printed circuit according to Claim 1, in which the distance between the fixed portion (33) and the distal point of the cantilevered portions (36) is greater than 35 mm.

3. Printed circuit according to any one of the preceding claims, in which the cantilevered portions comprise through orifices (35) located plumb with respective through orifices (21) of the substrate.

4. Printed circuit according to any one of the preceding claims, in which the said substrate exhibits a thickness of greater than 1.5 mm.

5. Printed circuit according to any one of the preceding claims, furthermore comprising surface mounted electronic components connected to at least one of said conducting tracks (57).

6. Printed circuit according to any one of the preceding claims, in which the interconnection element is made of a material chosen from the group comprising aluminium alloys and copper alloys.

7. Battery (1), comprising:
- a printed circuit (2) according to any one of the preceding claims;
- a support (5) to which the printed circuit is fixed;
- at least two electrochemical accumulators (4) housed in the said support and each comprising a terminal (41, 42) connected to a respective cantilevered portion of the interconnection element (31) of the printed circuit.

8. Battery according to Claim 7, in which the said electrochemical accumulators (4) each comprise two connection terminals (41, 42) disposed at one and the same end of the accumulator.

9. Battery according to Claim 8, comprising a compressible material (54) interposed between the support (53) and the opposite end of an accumulator from the end comprising the said connection terminals.

10. Battery according to Claim 7, 8 or 9 comprising a printed circuit according to Claim 1, and comprising screws (55) passing through the orifices of the cantilevered portions and securing the cantilevered portions to a respective terminal (41, 42) of the said accumulators.

11. Battery according to any one of Claims 7 to 10, in which the printed circuit comprises a circuit for balancing the charge of the said accumulators and which is connected to the said conducting tracks (56).

12. Battery according to any one of Claims 7 to 11, in which the printed circuit comprises
- two power output terminals (22, 23) of the battery;
- two other conducting interconnection elements (313, 314) connected electrically to a respective power output terminal, which are fixed to the substrate and which each connect terminals of several electrochemical accumulators.
